(19) Europäisches Patentamt / European Patent Office / Office européen des brevets

(11) **EP 2 365 630 B1**

(12) **EUROPEAN PATENT SPECIFICATION**

(45) Date of publication and mention
of the grant of the patent:
**08.06.2016 Bulletin 2016/23**

(51) Int Cl.:
***H03H 21/00*** *(2006.01)*

(21) Application number: **10155192.7**

(22) Date of filing: **02.03.2010**

(54) **Efficient sub-band adaptive fir-filtering**

Effiziente adaptive Subband-FIR-Filterung

Filtrage FIR adaptatif de sous-bande efficace

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**14.09.2011 Bulletin 2011/37**

(73) Proprietor: **Harman Becker Automotive Systems GmbH**
**76307 Karlsbad (DE)**

(72) Inventor: **Christoph, Markus**
**94315 Straubing (DE)**

(74) Representative: **Westphal, Mussgnug & Partner Patentanwälte mbB**
**Herzog-Wilhelm-Strasse 26**
**80331 München (DE)**

(56) References cited:
**EP-A2- 0 746 133**

• **WEISS S ET AL: "Adaptive equalisation in oversampled subbands" ELECTRONICS LETTERS, IEE STEVENAGE, GB LNKD-DOI:10.1049/EL:19981085, vol. 34, no. 15, 23 July 1998 (1998-07-23) , pages 1452-1453, XP006010115 ISSN: 0013-5194**

• **LARSON L-O ET AL: "A new subband weight transform for delayless subrand adaptive filtering structures" DIGITAL SIGNAL PROCESSING WORKSHOP, 2002 AND THE 2ND SIGNAL PROCESSING EDUCATION WORKSHOP. PROCEEDINGS OF 2002 IEEE 10TH 13-16 OCT. 2002, PISCATAWAY, NJ, USA,IEEE, 13 October 2002 (2002-10-13), pages 201-206, XP010657797 ISBN: 978-0-7803-8116-2**

• **DEBRUNNER L S ET AL: "Sub-Band Adaptive Filtering With Delay Compensation for Active Control" IEEE TRANSACTIONS ON SIGNAL PROCESSING, IEEE SERVICE CENTER, NEW YORK, NY, US LNKD-DOI:10.1109/TSP.2004.834340, vol. 52, no. 10, 1 October 2004 (2004-10-01), pages 2932-2937, XP011119376 ISSN: 1053-587X**

• **FARHANG-BOROUJENY B ET AL: "Adaptive filtering in subbands: Design issues and experimental results for acoustic echo cancellation" SIGNAL PROCESSING, ELSEVIER SCIENCE PUBLISHERS B.V. AMSTERDAM, NL LNKD- DOI:10.1016/S0165-1684(97)00106-0, vol. 61, no. 3, 1 September 1997 (1997-09-01), pages 213-223, XP004097824 ISSN: 0165-1684**

• **WEISS S ET AL: "Fast implementation of oversampled modulated filter banks" ELECTRONICS LETTERS, IEE STEVENAGE, GB LNKD- DOI:10.1049/EL:20001068, vol. 36, no. 17, 17 August 2000 (2000-08-17), pages 1502-1503, XP006015620 ISSN: 0013-5194**

**Description**

TECHNICAL FIELD

The present invention relates to sub-band signal processing in audio applications, in particular to a method for designing a set of sub-band FIR filters which provide a computationally efficient implementation of a desired target transfer function.

BACKGROUND

Publication EP 0 746 133 A2 describes a multistage echo canceller including time variation compensation. The echo canceller includes two cascaded echo canceller stages each including an adaptive filter, whereby in the second stage adjustable delay elements are connected to the adaptive filter upstream thereof.

In contrast to IIR filters (infinite impulse response filters) FIR filters (finite impulse response filters) provide for the possibility to realize digital filters having a desired transfer function (i.e. magnitude and phase response) which is arbitrarily definable. Thus, a desired transfer function can not only be designed to be minimum phase but also maximum phase or mixed phase as well. Further, linear phase transfer functions can also be implemented, which is often desired in audio signal processing

However, especially in audio signal processing the required filter lengths are often considerably high when using FIR filters, which increases the computational effort as well as the memory requirements during operation. This is mainly due to two physical facts. Firstly, the decay time of room impulse responses present in most audio applications is considerably long, which results in correspondingly long filter lengths when using FIR filters. Secondly, the human auditory system is adapted to provide a non-uniform frequency resolution over different frequency bands. The human auditory system resolves low frequencies quite well, i.e. frequency differences are recognized well at low absolute frequencies, whereas high frequencies are not discerned so easily. For example, a 100 Hz tone may be easily distinguished well from a 200 Hz tone whereas the human ear has difficulties distinguishing a 5000 Hz tone from a 5100 Hz tone, although the frequency difference is 100 Hz in both cases. That is, the frequency resolution of the human auditory system decreases with increasing frequencies. This phenomenon is well known and forms the basis for psychoacoustical frequency scales adapted to the human auditory system such as the Bark scale, the Mel scale, and ERB (equivalent rectangular bandwidth) scale.

Research has shown that, dependent on the interior (carpets, upholstered furniture, etc.), the room impulse responses of listening rooms are considerably long, especially at low frequencies because the degradation of energy is slow. This effect is even intensified by the fact that the sound pressure generated by an audio reproduction system is at a maximum in the bass frequency range (i.e. below 200 Hz) whereas the human auditory system is less sensitive to low frequency audio signals.

A consolidated view of all these factors indicates that the characteristics of the human auditory system as well as the characteristics of typical listening rooms require that the lengths of FIR filters not be shorter than a certain minimum length in order to provide sufficient audio quality in audio signal processing systems. For example, to provide a required frequency resolution of about 10 Hz in the bass frequency range a FIR filter with 4410 filter coefficients is required for each audio channel at a sampling frequency of 44100 Hz, whereby modern audio systems have up to 16 channels.

As long FIR filters entail considerable computational effort and/or high memory requirements during operation there is a need for an efficient implementation of FIR filters in audio applications in order to allow for the use of standard digital audio signal processing hardware thus creating a need for adequate filter design methods.

SUMMARY

The problems mentioned above are solved by a method for designing a set of sub-band FIR filters as defined in claim 1. Therein, each FIR filter has a number of filter coefficients and is connected to an adjustable delay line upstream or downstream thereof. The method comprises: dividing a input signal into a number of sub-band signals, the spectra of the sub-band signals composing the spectrum of the input signal; providing, for each sub-band, a respective desired sub-band signal dependent on a desired signal; filtering and delaying each sub-band signal, thus generating filtered signals using the corresponding FIR filter and delay line; providing, for each sub-band, error signals dependent on the filtered signals and the corresponding desired signals; adapting the filter coefficients of each sub-band FIR filter such that a norm of the respective error signal is minimized and, thus, the respective filtered signal appproximately matches the corresponding desired sub-band signal; and varying, for each sub-band, the respective delay of the delay line so as to minimize or maximize a first quality criterion.

## BRIEF DESCRIPTION OF THE DRAWINGS

The invention can be better understood referring to the following drawings and descriptions. In the figures like reference numerals designate corresponding parts. In the drawings:

FIG. 1    illustrates a basic signal processing structure for an adaptive calculation of filter coefficients of a FIR filter, the FIR filter representing a transfer function G(z) that approximately matches a predefined target function P (z) ;

FIG. 2    illustrates a modification of the structure of FIG. 1 whereby the full-band FIR filter G(z) of FIG. 1 is replaced by a set of sub-band FIR filters $G_m(z)$;

FIG. 3    illustrates the a signal processing structure comprising a set of sub-band FIR filters $G_m(z)$ which can replace a full-band FIR filter G(z);

FIG. 4    illustrates the a signal processing structure for adaptive FIR filter design including a number of sub-bands each comprising a sub-band FIR filter and a delay line;

FIG. 5    illustrates the weighting factors based on the Bark scale for emphasizing the low frequency subbands when adapting the lengths of the sub-bad FIR filters; and

FIG 6    schematically illustrates the magnitude response of an evenly stacked and an oddly stacked filter bank.

## DETAILED DESCRIPTION

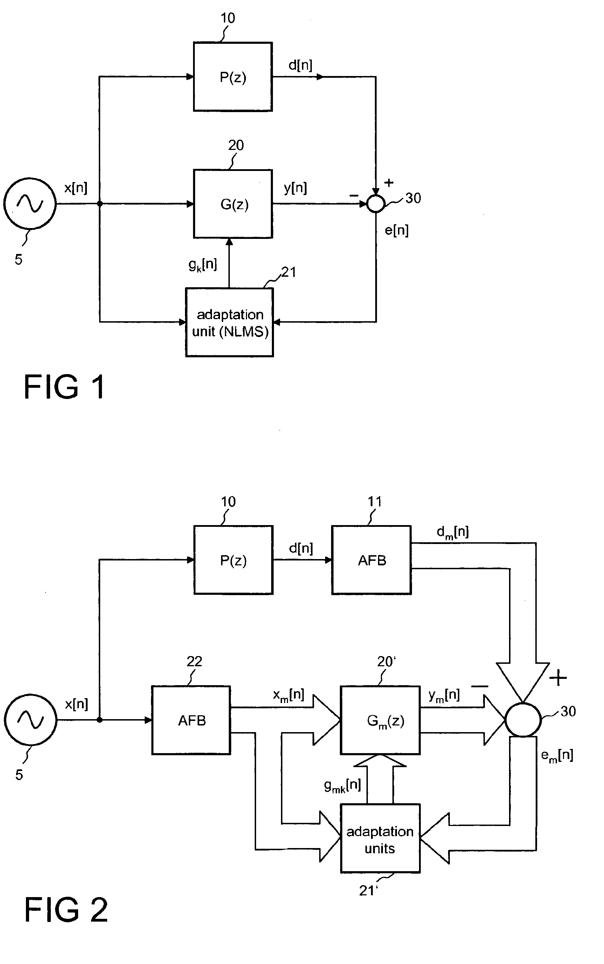

FIG. 1 illustrates a basic signal processing structure for an adaptive calculation of filter coefficients $g_k$ (k = 0, 1, ..., K-1) of a FIR filter 20 whereby the subscript k denotes the index of the filter coefficient and K denotes the filter length. The FIR filter 20 has a (discrete) transfer function G(z) which, after successful adaptation of the filter coefficients $g_k$, approximately matches a predefined target function P(z) of a reference system 10. In order to perform the adaptive filter design procedure the reference filter 10 and the FIR filter 20 are supplied with a test signal (input signal x[n]) which, for example, is white noise or any other signal having a band-width which includes the pass band of the target transfer function P(z). The output signal y[n] of the FIR filter 20 is subtracted (subtractor 30) from the output signal of the reference system 10, i.e. from the desired signal d[n]. The difference d[n]-y[n] is used as an error signal e[n] and supplied to an adaptation unit 21. The adaptation unit 21 is configured to calculate an updated set of FIR filter coefficients $g_k$ from the error signal and the input signal x[n] (also denoted as reference signal in this context) during each sample time interval. A Least-Mean-Square (LMS) algorithm or a Normalized-Least-Mean-Square (NLMS) algorithm may be employed for adaptation of the filter coefficients. However, different adaptation algorithms may be utilized for this purpose, as well. After convergence of the adaptation algorithm, the FIR filter coefficients $g_k$ represent a transfer function G(z) which is an optimum approximation of the target transfer function P(z).

One option for reducing the computational effort when using FIR filters is to divide the spectrum of the signal to be filtered into a number of narrow band signals (sub-band signals) and to separately filter each narrow band signal. The division of a full-band signal into several sub band signals may be implemented by means of a so-called analysis filter bank (AFB). Similarly, the sub-band signals may be (re-) combined to a single full-band signal with a corresponding synthesis filter bank (SFB). In the following, a full band signal is denoted without a subscript, e.g. the desired signal d[n], wherein n is the time index. Further, signals having a subscript, e.g. $d_m[n]$, denote a set of sub-band signals which are the decomposition of the corresponding full-band signal d[n]. Thereby, the subscript m denotes the number of the sub-band (m = 1, 2, ..., M). Analogously, a discrete full-band transfer function G(z) may be decomposed into a number of sub-band transfer functions $G_m(z)$.

FIG. 2 illustrates a basic signal processing structure similar to that in FIG. 1, whereby the adaptive FIR filter 20 is replaced by a set 20' of sub-band FIR filters. For this purpose, the full-band input signal x[n] is divided into a number M of sub-band input signals $x_m[n]$ (with m = 1, 2, ..., M) by using AFB 22. Analogously, the full-band desired signal d[n] is split into a number M of sub-band signals $d_m[n]$ using AFB 11 (again m = 1, 2, ..., M). Each sub-band FIR filter realized a narrow-band transfer function $G_m(z)$, the subscript m again denoting the number of the sub band. Each sub-band filter $G_m(z)$ may also be represented by its filter coefficients $g_{mk}$, whereby k again denotes the index of the filter coefficients ranging from k = 0 to k = $K_m$-1 ($K_m$ being the filter length of the filter $G_m(z)$ in the $m^{th}$ sub-band). Each FIR filter $G_m(z)$ is associated with an adaptation unit (the set of adaptation units is denoted by numeral 21' in FIG. 2), which receives the corresponding error signal $e_m[n]$ = $d_m[n]$ - $y_m$ [n] and calculates a respective set of updated filter coefficients $g_{mk}$ (k = 1, 2, ..., $K_m$-1) for the respective sub-band m.

Similar to the example of FIG. 1, the filter coefficients $g_{mk}$ of each one of the M sub-band FIR filters $G_m(z)$ are

adapted such that, after convergence of the adaptation algorithm, the overall transfer characteristic resulting from a combination of all sub-band transfer functions $G_m(z)$ matches the predefined target function $P(z)$.

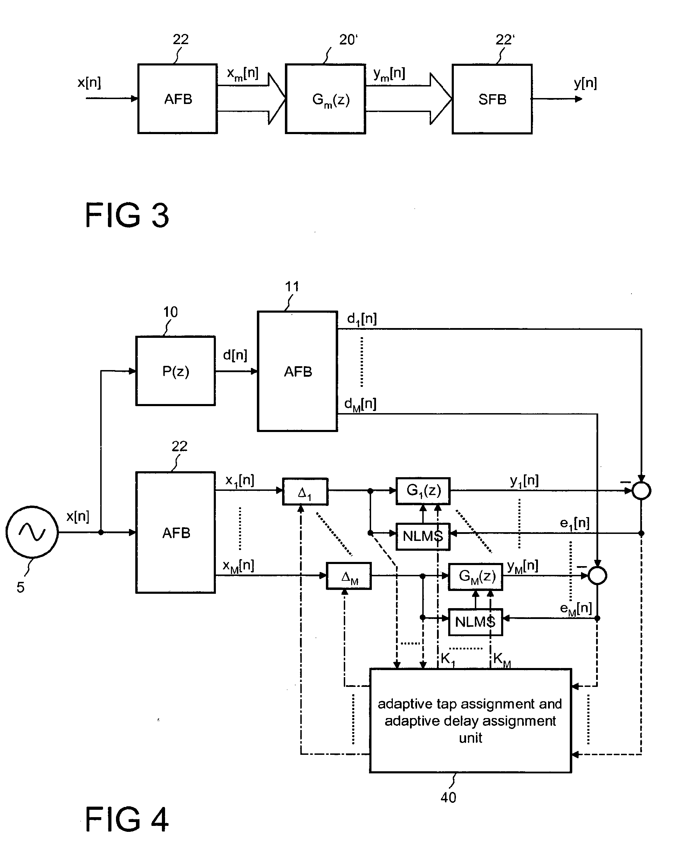

After calculation of appropriate filter coefficients $g_{mk}$, the set 20' of FIR filters $G_m(z)$ may be operated between an analysis filter bank (AFB 22) and a corresponding synthesis filter bank (SFB 22') as illustrated in FIG. 3 for filtering audio signals. In this case, the AFB 22, the FIR filter bank 20', and the SFB 22' together implement the transfer function $G(Z)$ that approximately matches a target function $P(z)$, which may represent, for example, an equalizing filter in an audio system. As in modern audio systems not only the magnitude but also the phase is subjected to equalization in order to generate a desired sound impression for a listener. Hence, the target function $P(z)$ generally represents a non minimum phase filter with a non linear phase characteristic.

The answer to the question of whether the signal processing structure of FIG. 3 comprising an analysis filter bank, a set of sub-band filters, and a synthesis filter bank is more efficient (in terms of computational effort and memory requirements) than an "ordinary" FIR filter with the same transfer function, depends inter alia on the availability of efficient implementations of the analysis and synthesis filter banks. In order to account for the non-uniform frequency resolution of the human auditory system it would be desirable to use a filter bank where the band widths of the sub bands with low center frequencies is narrower than the band widths of sub-bands with higher center frequencies. Several approaches exist to realizing such a psychoacoustically motivated division of full-band signals into a set of sub-band signals whose bandwidths depend on the position of the respective sub-band within the audible frequency range. However, no efficient filter bank is known that allows to non-uniformly divide an input spectrum into a set of sub-bands of different band-widths. Nevertheless, other methods are known in the art that allow for division of full-band signals into a set of sub-band signals of equal band-width. One example is the fast implementation of oversampled GDFT filter banks as described by S. Weiss et al (see S. Weiss, R. W. Stewart, "Fast Implementation of Oversampled Modulated Filter Banks", in: IEE Electronics Letters, vol. 36, pp. 1502-1503, 2000), which makes use of a single prototype filter and the FFT algorithm which is available in almost every signal processing environment.

Summarizing the above, filter banks should be used that operate with sub-bands of equal band widths, as efficient implementations are not available for handling sub-bands of non-uniform bandwidth. To alleviate the insufficiency of equally wide sub-bands, however, different filter lengths of the FIR filters assigned to respective sub-bands may be chosen. That is, FIR filters comprise fewer filter coefficients in sub-bands where low frequency resolution is required than in sub-bands where a high frequency resolution is required. The latter sub-bands are usually those which lie in the lower part of the audible frequency range. Thus a frequency resolution that corresponds to the frequency resolution of the human auditory system may be achieved by using efficient filter banks operating with equally wide sub bands.

As mentioned above, the target function $P(z)$ is generally a non minimum phase filter which has a non-linear group-delay characteristic over frequency. In order to compensate for different signal propagation delays due to different group delays in different sub-bands, a delay line may be connected to each sub-band FIR filter upstream or downstream thereof. Thus, the delay equalization does not need to be achieved using additional FIR filter coefficients, which are computationally inefficient. As the delay values as well as the number of filter coefficients depend on the target transfer function $P(z)$ (i.e. magnitude and phase response) to be realized, the number of filter coefficients (i.e. number of filter "taps") as well as the delay values may be adaptively determined for each sub-band as described herein below as "Adaptive Tap Assignment" and "Adaptive Delay Assignment" algorithms. Consequently, not only the filter coefficients (see coefficients $g_{mk}$ in FIG. 1) but also the number $K_M$ of coefficients and an additional delay $\Delta_m$ is adaptively determined when designing the M sub-band FIR filters $G_m(z)$. FIG. 4 illustrates the signal processing structure used for the sub-band FIR filter design. The example of FIG. 4 is an enhanced version of the structure of FIG. 2 with additional delays in each sub-band signal path and a global "adaptive tap assignment and delay assignment unit".

As in the example of FIG. 2, a full-band input signal $x[n]$ (e.g. band-limited white noise) is supplied to the system 10 with the target transfer function $P(z)$, thus generating the desired signal $d[n]$. The desired signal $d[n]$, as well as the input signal $x[n]$, are divided into a number M of sub-band signals $d_m[n]$ and $x_m[n]$, respectively. The example of FIG. 4 illustrates only the components and signals associated with the first and the last sub-band (m = 1 and m = M). The sub-band input signals $x_m[n]$ are supplied to the adaptive FIR filters with transfer function $G_m(z)$, thus generating filtered sub-band signals $y_m[n]$. Each filtered sub-band signals $y_m[n]$ is subtracted from the corresponding desired signal $d_m[n]$, yielding an error signal $e_m[n]$ for each sub-band. An adaptation unit is assigned to each FIR filter $G_m(z)$ for optimizing the filter coefficients $g_{mk}$ (i.e. the impulse response $\{g_{m0}, g_{m1}, ..., g_{m(K-1)}\}$ of the filter) of the respective FIR filter $G_m(z)$, where by the optimum set of filter coefficients $g_{mk}$ minimizes a norm (e.g. the power) of the respective error signal $e_m[n]$.

A delay line providing a delay $\Delta_m$ is connected upstream or downstream to each sub-band FIR filter $G_m(z)$. Further, an "adaptive tap assignment and adaptive delay assignment unit" 40 is provided which is configured to dynamically adapt the filter lengths $K_m$ of the FIR filters $G_m(k)$ as well as the corresponding delay values of the delay lines $\Delta_m$ in accordance with an adaptive tap assignment and adaptive delay assignment algorithm described below in more detail.

Different approaches may be considered for the above-mentioned adaptive tap assignment (i.e. the adaptation of FIR filter lengths). One approach is to vary the filter lengths $K_m$ of the sub-band FIR filters $G_m(z)$ until the total error signal $e[n]$ (whereby $e[n] = e_1[n] + e_2[n] + ... + e_M[n]$) reaches a minimum. In practice such a method yields good results but is quite time-consuming as, after each change in the number of filter coefficients, the adaptive filters need time to converge again. Another approach which yields similarly good results as the previous one but is much less time-consuming considers the energy of the S endmost filter coefficients $g_{m(Km-1)}$, $g_{m(Km-2)}$, ..., $g_{m(Km-S)}$. The filter length $K_m$ of a sub-band filter $G_m(z)$ is varied until the energy of the mentioned S endmost filter coefficients is approximately equal. This approach requires the impulse response of the sub-band filter to decay exponentially over time, which should be always the case in real-world systems. Comparing the energies of the S endmost filter taps of each sub-band filter allows to assess how well the sub-band filters $G_m(z)$ approximate the target function $P(z)$ and to provide a rule for re-distributing filter coefficients across the sub-band filters so as to achieve sub-band filter impulse responses whose signal decay behavior is like the signal decay behavior of the impulse response of the target function $P(z)$, which can be regarded as an optimum regarding minimized errors.

Below, examples of the adaptive tap assignment algorithms are described in more detail. It should be noted that for real-valued full-band input signals $x[n]$ (see FIG. 2) only M/2 sub-bands have to be processed since the other M/2 sub-band signals are conjugate complex copies of the signals in the first M/2 sub-bands. Thus, the respective sub-band FIR filter transfer functions obey the relationship

$$G_m(z) \; = \; G_{M-m+1}(z)*, \; \text{for} \; m \; = \; 1, \; ... \; M/2, \tag{1}$$

whereby the asterisk denotes the complex conjugate operator.

Accordingly, the filter lengths $K_m$ of the sub-band filters $G_m(z)$ (whereby m = 1, 2, ..., M/2) are modified with a period of Q samples (i.e. samples in the sub-bad systems). The total number of filter coefficients $g_{mk}[n]$ of all sub-band filters $G_m(z)$ remain, however, constant. That is, if the filter length of one or more sub-band filters increases, the filter length of another sub-band filter has to be reduced so as to keep the total number of filter coefficients constant. Accordingly, with a period of Q samples, the length of each of the M/2 sub-band FIR filters is reduced by $\Delta K$ coefficients. Consequently there are $\Delta K \cdot M/2$ "free" coefficients which are re-distributed throughout the M sub-band filters according to certain criteria further described below.

The above "re-distribution" may be expressed by the following equation

$$K_m[\frac{n}{Q} + 1] \; = \; K_m[\frac{n}{Q}] \; - \; \Delta K \; + \; \Delta K \; \cdot \; \frac{M}{2} \; \cdot \; \frac{c_m[\frac{n}{Q}]}{\sum_{i=1}^{M/2} c_i[\frac{n}{Q}]}, \tag{2}$$

whereby m = 1, 2, ..., M/2 denotes the number of the sub-band. The expression $c_m[n/Q]$ represents the above-mentioned criterion for the distribution of filter taps (i.e. filter coefficients). As mentioned above, one useful criterion is the energy of the sub-band error signal $e_m[n]$. In this case $c_m[n/Q]$ can be expressed as

$$c_m[\frac{n}{Q}] \; = \; \frac{1}{R} \sum_{r=0}^{R-1} e_m[n - r] \cdot e_m^*[n - r], \tag{3}$$

whereby m = 1, 2, ..., M/2 and R is the number of samples over which the error signal is averaged. However, the adaptive sub-band FIR filter has to converge before eqn. (3) is evaluated and, consequently, R needs to be much smaller than Q (i.e. R << Q). Another criterion considers the energy of the endmost S filter coefficients of the respective sub-bad FIR filter. In this case $c_m[n/Q]$ can be expressed as

$$c_m[\frac{n}{Q}] \; = \; \frac{1}{S} \sum_{s=0}^{S-1} g_{m(Km-s)}[n] \cdot g_{m(Km-s)}^*[n], \tag{4}$$

whereby m = 1, 2, ..., M/2, and $K_m$ is the current filter lengths $K_m[n]$ in the respective sub-band. Alternatively, the energy of the sub-band input signals $x_m[n]$ may be considered together with the endmost S filter coefficients (see eqn. 5). In this case $c_m[n/Q]$ can be expressed as

$$c_m\left[\frac{n}{Q}\right] = \frac{1}{R}\sum_{r=0}^{R-1} x_m[n-r] \cdot x_m^{*}[n-r] + \frac{1}{S}\sum_{s=0}^{S-1} g_{m(K_m-s)}[n] \cdot g_{m(K_m-s)}^{*}[n]. \qquad (5)$$

As mentioned above, the criterion according to eqn. (3) yields the best results but is time-consuming to evaluate.

The criterion according to eqn. (5) should be used when the target system is time-varying and the input signals are arbitrarily colored, as may be the case in AEC (acoustic echo canceling) systems. In the present case, i.e. for sub-band FIR filter design, where the input signal x[n] may be chosen by the designer to be white noise, eqn. (4) yields good quality results and simultaneously allows for a fast adaptation.

In order to account for psycho-acoustic aspects the expression $c_m$ as defined in eqn. (3), (4), or (5) may be weighted with a corresponding weighting factor $w_m$, i.e. the expression $c_m[n/Q]$ is replaced by $w_m \cdot c_m[n/Q]$ in eqn. (3), (4), or (5). The weighting factors $w_m$ should be chosen such that the frequency resolution of the human auditory system is considered. Using the Bark scale the factors $w_m$ can be calculated as follows

$$w_m = 13 \tan^{-1}\left(0.76\frac{f_{c,m}+1}{1000}\right) + 3.5 \tan^{-1}\left(\left(\frac{f_{c,m}+1}{7500}\right)^2\right) -$$

$$\qquad (6)$$

$$13 \tan^{-1}\left(0.76\frac{f_{c,m}}{1000}\right) - 3.5 \tan^{-1}\left(\left(\frac{f_{c,m}}{7500}\right)^2\right),$$

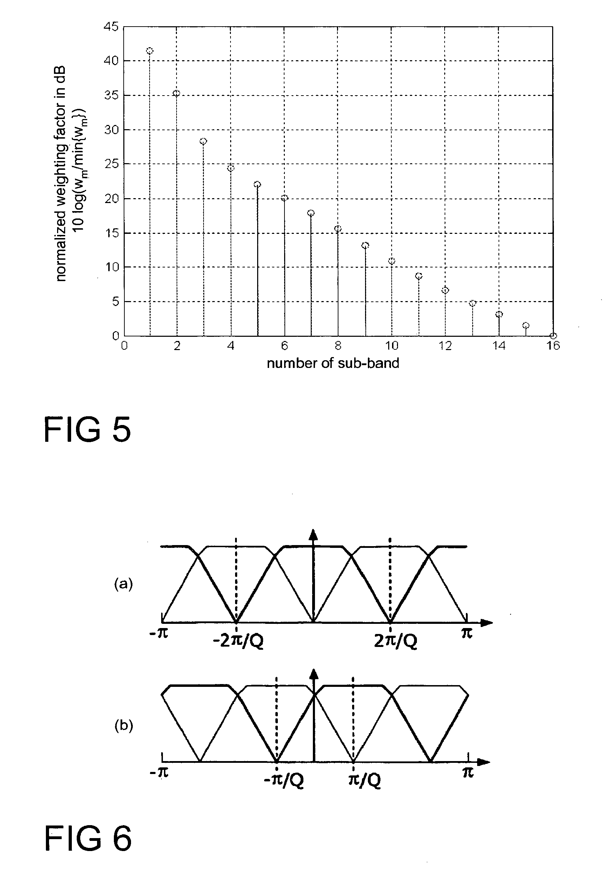

where $f_{c,m}$ denotes the center frequency (in Hz) of the $m^{th}$ sub-band which may be calculated as $f_{c,m} = (2m-1)\cdot f_s/(2\cdot M)$, $f_s$ being the sampling frequency in Hz. An example set of normalized weighting factors $w_m$ which were calculated in accordance with eqn. (6) are illustrated in FIG 5, whereby a number of 16 sub-bands were considered (M/2 = 16).

As mentioned above, the re-distribution of coefficients in accordance to eq. (2) "equalizes" either the energy of the sub-band error signals $e_m[n]$ (cf. eq. (3)) or the energy of a part (e.g. the endmost S filter coefficients) of the sub-band filter-coefficients $g_{mk}$ (where k = {$K_m$-S, ..., $K_m$-1}, cf. eq. (4)) or a combination of energies of the sub-band filter-coefficients $g_{mk}$ and the sub-band input signals $x_m[n]$ (cf. eq. (5)). Different energy-based criteria are possible. The "goal" of the algorithm is thus an equal distribution of signal energies across the sub-bands. As this goal is the desired outcome of an optimization process, the above described algorithm can also be seen as a minimization (or maximization) task.

In an ideal case the above mentioned criteria $c_m[n/Q]$ (see eqn. (3) to (5)) have equal values in each sub-band m whereby

$$\frac{1}{M/2} = \frac{c_m\left[\frac{n}{Q}\right]}{\sum_{i=1}^{M/2} c_i\left[\frac{n}{Q}\right]}, \qquad (7)$$

That is, in each one of the M/2 considered sub-bands the criterion $c_m[n]$ is a factor 2/M smaller than the total value of $c_m[n]$ summed over all sub-bands. Returning to the above-mentioned minimization task, the quality function to be minimized can written as:

$$q_m = \left|\frac{c_m\left[\frac{n}{Q}\right]}{\sum_{i=1}^{M/2} c_i\left[\frac{n}{Q}\right]} - \frac{2}{M}\right|. \qquad (8)$$

As mentioned above, the FIR filters $G_m(z)$ generally have different group delays in different sub-bands resulting in different signal propagations delays. In order to compensate for such differing delays each FIR filter is connected to an adjustable delay line upstream or downstream thereto in each sub-band. Again, the delay values in the sub-bands can be iteratively optimized as described below as "adaptive delay assignment".

The FIR filter coefficients which are adaptively assigned to the FIR filters in the sub-bands as explained above as "adaptive tap assignment" can be considered infinite impulse responses truncated by multiplication with a rectangular window function yielding a finite impulse response. For each sub-band FIR filter, this rectangular window function may be shifted (along the time axis), whereby the respective time-shift represents the effective delay of the delay line connected to the corresponding FIR filter.

The adaptive delay assignment algorithm described herein is targeted to find, for each sub-band, a delay value (i.e. a time-shift of the rectangular window mentioned above) that results in a maximum energy finite impulse response of the respective FIR filter. That is, when assigning the delay values to the respective delay lines only the energy or the corresponding FIR filter coefficients are considered. However, this is not necessarily the only successful approach. As an alternative, the delay values may be chosen such that a norm of the total error signal $e[n] = e_1[n] + e_2[n] + ... + e_{M/2}[n]$ is minimized. As already mentioned with regard to the adaptive tap assignment algorithm, the use of such a criterion will result in a slow convergence, while yielding sufficiently good results. Alternatively, the delay values may be chosen such that the total energy of the respective FIR filter coefficients is at a maximum.

However, as the FIR impulse responses (i.e. the FIR filter coefficients) of the sub-band filters generally include causal and acausal components due to the conversion into sub-bands, other criteria for finding optimum delay values may be targeted to equalize the energy of the causal and the acausal part of the respective impulse response, i.e. the difference between the energy of the first half and the energy of the second half of the respective sub-band FIR impulse response is to be minimized. Such an optimizing strategy may shortly be summarized as follows:

> For each sub-band m, define a first part and a second part of the respective sub-band FIR impulse response $g_{mk}$ and calculate the energy of the first part and the second part of the FIR impulse response. Repeat the following with a period of V samples:
>
> > (A) If the energy of the first part of the FIR impulse response $g_{mk}$ is greater than the energy of the second part of the impulse response, then increase the delay of the respective delay line $\Delta_m$ by P taps (e.g. P = 1).
> >
> > (B) If the energy of the first part of the FIR impulse response $g_{mk}$ is lower than the energy of the second part of the impulse response, then decrease the delay of the respective delay line $\Delta_m$ by P taps (e.g. P = 1). The minimum delay, however, is zero.
> >
> > (C) If both energies are equal, then leave the delay unchanged.

One might be tempted to divide the FIR impulse response into two parts of equal length. However, this would only yield good results for impulse responses whose maximum is located approximately in the middle of the impulse response. Considering a causal impulse response having its maximum at the left side, the above optimizing strategy would time shift the above-mentioned rectangular window to the right until the energy is equally distributed, thus inserting zeros on the left side of the impulse response, which is clearly undesirable. Therefore, better results are achieved in practice if the above mentioned first and second parts of the FIR impulse responses do not cover the entire length of the respective impulse response but only the upper and the lower margin thereof, defined by a variable U, whereby $0 < U < 1$. To give an example, if U = 0.6 then only 60 per cent of the filter coefficients are considered when calculating the energy, whereby the lower 30 per cent form the above-mentioned first part and the upper 30 per cent the corresponding second part. Thus, in the $m^{th}$ sub-band the energies $E_{mL}$ and $E_{mU}$ of the first part and the second part, respectively, are

$$E_{mU}[n] = \sum_{u=0}^{\lceil Km \frac{U}{2} \rceil} g_{m(Km-u)}[n] \cdot g_{m(Km-u)}^{*}[n], \qquad (9)$$

$$E_{mL}[n] = \sum_{u=\lfloor (1-\frac{U}{2})Km \rfloor}^{Km} g_{m(Km-u)}[n] \cdot g_{m(Km-u)}^{*}[n]. \qquad (10)$$

Thus, the delay value $\Delta_m$ is increased if $E_{mU} < E_{mL}$, decreased if $E_{mU} > E_{mL}$, and left unchanged if $E_{mU} = E_{mL}$, or expressed in mathematical terms

$$\Delta_m[n/V] = \begin{cases} \Delta_m[n/V-1] + P & \text{if } E_{mU} < E_{mL} \\ \max\{\Delta_m[n/V-1] - P,\ 0\} & \text{if } E_{mU} > E_{mL} \\ \Delta_m[n/V-1] & \text{if } E_{mU} = E_{mL} \end{cases} \qquad (10)$$

Generally the adaptive delay assignment algorithm can also be seen as a minimization task whereby, in each sub-band, the respective delay value $\Delta_m$ is varied until the quality criterion $c'_m[n/V] = |E_{mU}-E_{mL}|$ reaches a minimum, whereby the index n/V indicates that the criterion is only evaluated every $V^{th}$ sample time.

One should note that, when adjusting (e.g. increasing) the delay value $\Delta_m$ of a delay line in one sub-band by a number of taps, the corresponding filter impulse response (FIR filter coefficients) is shifted to the left, thus keeping the total delay (including the delays of delay line and FIR filter) constant. This avoids the need for a long re-adaptation of the FIR filter coefficients due to the variation of the delay value $\Delta_m$. However, the adaptation period with which the adaptive delay assignment as well as the adaptive tap assignment is performed should be considerable longer than the adaptation step width of the LMS /NLMS algorithm, so that the adaptation of the FIR filter coefficients $g_{mk}$ is in a steady state when the adaptive tap assignment and adaptive delay assignment are initiated.

Although the adaptive adjustment of filter lengths as well as the adaptive adjustment of additional delays in each sub-band can be usefully combined, both adaptation methods (adaptive tap assignment and adaptive delay assignment) may be used on its own, independently from each other. For example, the number of filter coefficients may be pre-defined for each sub-band (e.g. in accordance with the Bark scale) and the delays $\Delta_m$ may be adaptively adjusted as explained above. Further the adaptive determination of the filter lengths may be performed in accordance with the adaptive tap assignment method explained above without separate delay units or with fixed and predefined delays. This may be especially appropriate in cases where the desired target function P(z) is a linear phase or a minimum phase transfer function.

As already mentioned above, the analysis filter bank as well as the corresponding synthesis filter banks (cf. filter banks 22 and 22' in FIG. 3) divide the real-valued full-band input signal x[n] into a set of complex-valued sub-band signals $x_m[n]$ and re-combine the complex-valued filtered sub-band signals $y_m[n]$ to a real-valued output signal y[n]. However, other filter banks can be used that only operate with real-valued sub-band signals. In this case the sub-band FIR filters may be implemented more efficiently, however, the real-valued filter banks require twice as many MACs (multiply-accumulate operations) as the corresponding complex-valued filter banks. Further, the sub-bands may be under-sampled by a factor M when using complex sub-band signals whereas, in contrast, the maximum under-sampling factor is only M/2 when using real-valued filter banks. Finally, the required filter lengths of the sub-band FIR filters are only half of the lengths required when using real-valued sub-band signals. This indicates that the use of complex-valued AFBs and SFBs requires less computational effort than real-valued filter banks. However both types of filter banks are applicable for the use in the present invention.

When using complex-valued filter banks one can choose between evenly stacked or oddly stacked filter banks. Both types may be efficiently implemented by means of the generalized discrete Fourier transform algorithm (GDFT algorithm). FIG. 6 illustrates the sub-bands of an evenly stacked (FIG. 6a) as well as an oddly stacked (FIG. 6b) filter bank. Prima facie, the use of an oddly stacked GDFT filter bank seems to be preferable, as half of the M sub-bands are complex conjugate copies of the other half of the M sub-bands and consequently only a number of M/2 complex-valued sub-band signals have to be processed. When using an evenly stacked GDFT filter bank the lowest and the highest sub-bands are real-valued but only have half the band widths of the other sub-bands. Consequently, a number of M/2+1 sub-band signals have to be processed whereby the signals in the lowest sub-band are real-valued. As a consequence, the memory requirements are only half and the required MACs only a quarter in the lowest sub-band as compared to a complex-valued sub-band. Considering the fact, that the FIR filter $(G_1(z))$ of the lowest sub-band has the most filter coefficients $g_{1k}$ (when considering e.g. a frequency resolution according to Bark or any other psycho-acoustically adapted frequency scale) the overall efficiency improves by 25 per cent in terms of memory required and by 50 per cent in terms of MACs required, although the total number of sub-bands to be processed increases from M/2 to M/2+1.

Although the present invention and its advantages have been described in detail, it should be understood that various changes, substitutions, and alterations can be made herein without departing from the scope of the invention as defined by the appended claims.

## Claims

1. A method for designing a set.of sub-band FIR filters $(G_m(z))$, each FIR filter $(G_m(z))$ having a number $(K_m)$ of filter coefficients $(g_{mk})$ and being connected to an adjustable delay line upstream or downstream thereto; the method comprises:

dividing an input signal ($x[n]$) into a number (M) of sub-band signals ($x_m[n]$), the spectra of the sub-band signals composing the spectrum of the input signal;

providing, for each sub-band, a respective desired sub-band signal ($d_m[z]$) dependent on a desired signal ($d[n]$);

filtering and delaying each sub-band signal ($x_m[n]$) thus generating filtered signals ($y_m[n]$) using the corresponding FIR filter ($G_m(z)$) and delay line, respectively;

providing, for each sub-band, error signals ($em[n]$) dependent on the filtered signals ($y_m[n]$) and the corresponding desired signals ($d_m[n]$); **characterized by**

adapting the filter coefficients ($g_{mk}$) of each sub-band FIR filter ($G_m(z)$) such that a norm of the respective error signal ($em[n]$) is minimized and, thus, the respective filtered signal ($y_m[n]$) approximately matches the corresponding desired sub-band signal ($d_m[n]$); and

varying, for each sub-band, the respective delay ($\Delta_m$) of the delay line so as to minimize or maximize a first quality criterion ($c_m'[n/V]$).

2. The method of claim 1, where the impulse responses of the sub-band FIR filters ($G_m(z)$) differ from each other in accordance with a psycho-acoustically motivated frequency scale, in particular with the Bark scale, the Mel scale or the ERB scale.

3. The method of claim 1 or 2 further comprising

varying, for each sub-band, the number ($K_m$) of filter coefficients ($g_{mk}$) of the respective FIR filter ($G_m(z)$) so as to minimize or maximize a second quality criterion ($c_m[n/Q]$).

4. The method of one of claims 1 to 3, where, for each sub-band, the first quality criterion ($c_m'[n/V]$) depends on the energy of the filter coefficients of the respective sub-band FIR filter ($G_m(z)$).

5. The method of claim 4, further comprising

defining, for each sub-band, a first sub-set of filter coefficients of the respective sub-band FIR filter;

defining, for each sub-band, a second sub-set of filter coefficients of the respective sub-band FIR filter;

wherein the first quality criterion ($c_m'[n/V]$) assumes a minimum if, in the respective sub-band, the energy of the first sub-set of filter coefficients equals the energy of the second sub-set of filter coefficients.

6. The method of one of the claims 1 to 3, further comprising calculating a norm of the sum of the error signals of each sub-band

$$(\|e[n]\| = \|e_1[n] + e_2[n] + ... + e_{M/2}[n]\|),$$

the first quality criterion ($c_m'[n/V]$) assuming a minimum if, the norm becomes minimal.

7. The method of one of the claims 1 to 6, where the step of dividing the input signal into a number of sub-band signals comprises filtering the input signal using an evenly stacked generalized DFT filter bank.

8. The method of claim 7 where the sub-band input signal ($x_m[n]$) and the corresponding FIR filter coefficients are real-valued in the lowest and the highest sub-band (M = 1) and complex-valued in the other sub-bands (M=2, ..., M/2+1).

9. The method of claim 3, where the second quality criterion ($c_m(n/Q)$) depends on the energy of the sub-band error signal or the energy of the sub-band input signal or the energy of the sub-band FIR filter coefficients or a combination thereof.

10. The method of claim 9 where the second equality criterion ($c_m(n/Q)$) depends on the energy of a subset of consecutive filter coefficients including the endmost filer coefficient.

11. The method of claim 9 where the second quality criterion ($c_m(n/Q)$) depends on the energy of the sub-band error signal considering only a given number of consecutive samples of the respective error signal including the latest sample thereof ($em[n]$, $e_m[n-1]$, ..., $em[n-R]$).

**12.** The method of claim 3 where the second quality criterion ($c_m(n/Q)$) is weighted in each sub-band, whereby the weighting factor represents the frequency resolution of the human auditory system.

**Patentansprüche**

**1.** Verfahren zum Auslegen eines Satzes von Teilband-FIR-Filtern ($G_m(z)$), wobei jedes FIR-Filter ($G_m(z)$) eine Anzahl ($K_m$) von Filterkoeffizienten ($g_{mk}$) aufweist und mit einer einstellbaren Verzögerungsleitung verbunden ist, die ihm vor- oder nachgeschaltet ist; wobei das Verfahren Folgendes umfasst:

Teilen eines Eingangssignals ($x[n]$) in eine Anzahl (M) von Teilbandsignalen ($x_m[n]$), wobei die Spektren der Teilbandsignale das Spektrum des Eingangssignals umfassen;
Bereitstellen, für jedes Teilband, eines jeweiligen gewünschten Teilbandsignals ($d_m[z]$) abhängig von einem gewünschten Signal ($d[n]$);
Filtern und Verzögern jedes Teilbandsignals ($x_m[n]$), wodurch gefilterte Signale ($y_m[n]$ erzeugt werden, jeweils mithilfe des entsprechenden FIR-Filters ($G_m(z)$) bzw. der Verzögerungsleitung;
Bereitstellen, für jedes Teilband, von Fehlersignalen ($em[n]$) abhängig von den gefilterten Signalen ($y_m[n]$) und den entsprechenden gewünschten Signalen ($d_m[n]$); **gekennzeichnet durch**
Anpassen der Filterkoeffizienten ($g_{mk}$) jedes Teilband-FIR-Filters ($G_m(z)$) derart, dass eine Norm des jeweiligen Fehlersignals ($e_m[n]$) minimiert wird und **dadurch** das jeweilige gefilterte Signal ($y_m[n]$) ungefähr mit dem entsprechenden gewünschten Teilbandsignal ($d_m[n]$) übereinstimmt; und
Variieren, für jedes Teilband, der jeweiligen Verzögerung ($\Delta_m$) der Verzögerungsleitung, um ein erstes Qualitätskriterium ($c_m'[n/V]$) zu minimieren oder zu maximieren.

**2.** Verfahren nach Anspruch 1, wobei die Impulsantworten der Teilband-FIR-Filter ($G_m(z)$) sich entsprechend einer psychoakustisch motivierten Frequenzskala, insbesondere einer Bark-Skala, der Mel-Skala oder der ERB-Skala, voneinander unterscheiden.

**3.** Verfahren nach Anspruch 1 oder 2, ferner umfassend

Variieren, für jedes Teilband, der Anzahl ($K_m$) von Filterkoeffizienten ($g_{mk}$) des jeweiligen FIR-Filters ($G_m(z)$), um ein zweites Qualitätskriterium ($c_m[n/Q]$) zu minimieren oder zu maximieren.

**4.** Verfahren nach den Ansprüchen 1 bis 3, wobei für jedes Teilband das erste Qualitätskriterium ($c_m'[n/V]$) von der Energie der Filterkoeffizienten des jeweiligen Teilband-FIR-Filters ($G_m(z)$) abhängt.

**5.** Verfahren nach Anspruch 4, ferner umfassend

Definieren, für jedes Teilband, eines ersten Teilsatzes von Filterkoeffizienten des jeweiligen Teilband-FIR-Filters;
Definieren, für jedes Teilband, eines zweiten Teilsatzes von Filterkoeffizienten des jeweiligen Teilband-FIR-Filters;
wobei das erste Qualitätskriterium ($c_m'[n/V]$) ein Minimum annimmt, wenn in dem jeweiligen Teilband die Energie des ersten Teilsatzes von Filterkoeffizienten gleich der Energie des zweiten Teilsatzes von Filterkoeffizienten ist.

**6.** Verfahren nach einem der Ansprüche 1 bis 3, ferner umfassend

Berechnen einer Norm der Summe der Fehlersignale jedes Teilbands

$$(\|e[n]\| = \|e_1[n] + e_2[n] + ... + e_{M/2}[n]\|),$$

wobei das erste Qualitätskriterium ($c_m'[n/V]$) ein Minimum annimmt, wenn die Norm minimal wird.

**7.** Verfahren nach einem der Ansprüche 1 bis 6, wobei der Schritt des Teils des Eingangssignals in eine Anzahl von Teilbandsignalen Filtern des Eingangssignals unter Verwendung einer gleichmäßig gestapelten verallgemeinerten DFT-Filterbank umfasst.

8. Verfahren nach Anspruch 7, wobei das Teilbandeingangssignal ($x_m[n]$) und die entsprechenden FIR-Filterkoeffizienten im niedrigsten und höchsten Teilband einen reellen Wert aufweisen (M = 1) und in den anderen Teilbändern einen komplexen Wert aufweisen

$$(M = 2, \ldots M/2+1).$$

9. Verfahren nach Anspruch 3, wobei das zweite Qualitätskriterium ($c_m(n/Q)$) von der Energie des Teilbandfehlersignals oder der Energie des Teilbandeingangssignals oder der Energie der Teilband-FIR-Filterkoeffizienten oder einer Kombination davon abhängt.

10. Verfahren nach Anspruch 9, wobei das zweite Qualitätskriterium ($c_m(n/Q)$) von der Energie eines Teilsatzes von aufeinander folgenden Filterkoeffizienten abhängt, einschließlich des letzten Filterkoeffizienten.

11. Verfahren nach Anspruch 9, wobei das zweite Qualitätskriterium ($c_m(n/Q)$) von der Energie des Teilbandfehlersignals unter Berücksichtigung nur einer gegebenen Anzahl von aufeinanderfolgenden Abtastungen des jeweiligen Fehlersignals einschließlich der letzten Abtastung davon (em[n], $e_m[n-1]$, ... $e_m[n-R]$) abhängt.

12. Verfahren nach Anspruch 3, wobei das zweite Qualitätskriterium ($c_m(n/Q)$) in jedem Teilband gewichtet wird, wobei der Gewichtungsfaktor die Frequenzauflösung des menschlichen Gehörs darstellt.


**Revendications**

1. Procédé pour la désignation d'un ensemble de filtres FIR de sous-bande ($G_m(z)$), chaque filtre FIR ($G_m(z)$) ayant un nombre ($K_m$) de coefficients de filtre ($g_{mk}$) et étant connecté à une ligne de retard ajustable en amont ou en aval par rapport à ceux-ci ; le procédé comprend :

la division d'un signal d'entrée (x[n]) en un nombre (M) de signaux de sous-bande ($x_m[n]$), les spectres des signaux de sous-bande composant le spectre du signal d'entrée ;
la fourniture, pour chaque sous-bande, d'un signal de sous-bande souhaité respectif ($d_m[z]$) dépendant d'un signal souhaité (d[n]) ;
le filtrage et le retardement de chaque signal de sous-bande ($x_m[n]$) générant ainsi des signaux filtrés ($y_m[n]$) à l'aide du filtre FIR correspondant ($G_m(z)$) et de la ligne de retard, respectivement ;
la fourniture, pour chaque sous-bande, de signaux d'erreur (em[n]) dépendant des signaux filtrés ($y_m[n]$) et des signaux souhaités correspondants ($d_m[n]$) ; **caractérisé par**
l'adaptation des coefficients de filtre ($g_{mk}$) de chaque filtre FIR de sous-bande ($G_m(z)$) de telle sorte qu'une norme du signal d'erreur respectif ($e_m[n]$) est minimisée et, ainsi, le signal filtré respectif ($y_m[n]$) correspond approximativement au signal de sous-bande souhaité correspondant ($d_m[n]$) ; et
la variation, pour chaque sous-bande, du retard respectif ($\Delta m$) de la ligne de retard afin de minimiser ou de maximiser un premier critère de qualité (cm'[n/V]).

2. Procédé selon la revendication 1, où les réponses aux impulsions des filtres FIR de sous-bande ($G_m(z)$) diffèrent les unes des autres selon une échelle de fréquence à caractère psycho-acoustique, en particulier avec l'échelle de Bark, l'échelle de Mel ou l'échelle ERB.

3. Procédé selon la revendication 1 ou 2 comprenant en outre :

la variation, pour chaque sous-bande, du nombre ($K_m$) de coefficients de filtre ($g_{mk}$) du filtre FIR respectif ($G_m(z)$) afin de minimiser ou de maximiser un second critère de qualité ($c_m[n/Q]$).

4. Procédé selon l'une quelconque des revendications 1 à 3, où, pour chaque sous-bande, le premier critère de qualité ($c_m'[n/V]$) dépend de l'énergie des coefficients de filtre du filtre FIR de sous-bande respectif ($G_m(z)$).

5. Procédé selon la revendication 4, comprenant en outre :

la définition, pour chaque sous-bande, d'un premier sous-ensemble de coefficients de filtre du filtre FIR de sous-bande respectif ;

la définition, pour chaque sous-bande, d'un second sous-ensemble de coefficients de filtre du filtre FIR de sous-bande respectif ;

dans lequel le premier critère de qualité ($c_m$'[n/V]) suppose un minimum si, dans la sous-bande respective, l'énergie du premier sous-ensemble de coefficients de filtre est égale à l'énergie du second sous-ensemble de coefficients de filtre.

**6.** Procédé selon l'une quelconque des revendications 1 à 3, comprenant en outre

le calcul d'une norme de la somme des signaux d'erreur de chaque sous-bande

$$( \| e[n] \| = \| e_1[n] + e_2[n] + \ldots + e_{M/2}[n] \| ),$$

le premier critère de qualité ($c_m$'[n/V]) supposant un minimum si la norme devient minimale.

**7.** Procédé selon l'une quelconque des revendications 1 à 6, où l'étape de division du signal d'entrée en un nombre de signaux de sous-bande comprend le filtrage du signal d'entrée à l'aide d'une banque de filtres DFT généralisés empilés de manière uniforme.

**8.** Procédé selon la revendication 7 où le signal d'entrée de sous-bande ($x_m$[n]) et les coefficients de filtre FIR correspondant sont à valeurs réelles dans la sous-bande la plus faible et la plus élevée (M = 1) et à valeurs complexes dans les autres sous-bandes (M=2, ..., M/2+1).

**9.** Procédé selon la revendication 3, où le second critère de qualité ($c_m$(n/Q)) dépend de l'énergie du signal d'erreur de sous-bande ou de l'énergie du signal d'entrée de sous-bande ou de l'énergie des coefficients de filtre FIR de sous-bande ou d'une combinaison de celles-ci.

**10.** Procédé selon la revendication 9 où le second critère de qualité ($c_m$(n/Q)) dépend de l'énergie d'un sous-ensemble de coefficients de filtre consécutifs incluant le coefficient de filtre le plus extrême.

**11.** Procédé selon la revendication 9 où le second critère de qualité ($c_m$(n/Q)) dépend de l'énergie du signal d'erreur de sous-bande en prenant uniquement en considération un nombre donné d'échantillons consécutifs du signal d'erreur respectif incluant le dernier échantillon de celui-ci ($e_m$[n], $e_m$[n-1], ..., $e_m$[n-R]).

**12.** Procédé selon la revendication 3 où le second critère de qualité ($c_m$(n/Q)) est pondéré dans chaque sous-bande, moyennant quoi le facteur de pondération représente la résolution de fréquence du système auditif humain.

FIG 1

FIG 2

**FIG 3**

**FIG 4**

# FIG 5

# FIG 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0746133 A2

**Non-patent literature cited in the description**

- **S. WEISS ; R. W. STEWART.** Fast Implementation of Oversampled Modulated Filter Banks. *IEE Electronics Letters,* 2000, vol. 36, 1502-1503